# EUROPEAN PATENT APPLICATION

(11) **EP 2 244 309 A1**
(43) Date of publication of application: **27.10.2010**
(21) Application number: 08757348.1
(22) Date of filing: 26.05.2008
(51) Int. Cl.: H01L 33/00

(54) **LED PACKAGE STRUCTURE HAVING THE LED AND METHOD FOR FABRICATING THE LED**

(30) Priority: 19.01.2008 CN 200810025948
(71) Applicant: He Shan Lide Electronic Enterprise Company Ltd, He Shan, Guandong 529728 (CN)
(72) Inventor: FAN, Ben, He Shan Guangdong 529728 (CN); WENG, Joe, He Shan Guangdong 529728 (CN)
(74) Representative: Becker Kurig Straus
(86) International application number: PCT/CN2008/001012
(87) International publication number: WO 2009/089671

(57) **Abstract**

An LED includes a substrate (8), an n-type semiconductor material layer (7) formed on the face of the substrate (8), a luminous layer (6) formed on the n-type semiconductor material layer (7), a p-type semiconductor material layer (5) formed on the luminous layer (6), a protective layer (2), which covers the p-type semiconductor material layer (5), an anode (1) which penetrates the protective layer (2) and is formed on the p-type semiconductor material layer (5) and a cathode (4) which is surround n-type semiconductor material layer (7) and electric contacts with the n-type semiconductor material layer (7). The invention also provides a package structure having the LED and the method of manufacturing the LED.

## Description

### BACKGROUND OF THE INVENTION

### 1. Field of Invention

The present invention relates to a light-emitting diode, a package structure having the light-emitting diode and the method for fabricating the light-emitting diode, and more particularly to a light-emitting diode utilizing a circular cathode, a package structure thereof and a manufacturing method for the same.

### 2. Description of the Related Art

A light-emitting diode (LED) is a forward-biased p-n junction diode made of semiconductor materials. The light-emitting principle of the light-emitting diode is described as follows. When a forward electrical current is applied to two sides of the p-n junction of the light-emitting diode, non-equilibrium carriers (electrons-holes) recombine to emit light. The foregoing light-emitting process primarily corresponds to a spontaneous light-emitting process. Materials for manufacturing the light-emitting diode are heavily doped and to create the p-n junction. On a thermal equilibrium condition, the n-type region has a lot of mobile electrons with highly migrating frequency and the p-type region has a lot of holes with lowly migrating frequency. The p-n junction serves as an insulator and prevents electrons and holes from recombining. However, when a forward electrical current is applied to the p-n junction, electrons can overcome the built-in potential of the p-n junction and enter a side of the p-n junction near the p-type region. When electrons meet the hole in the side of the p-n junction, recombination occurs and light emits. The light emitted from this recombination belongs to spontaneous emission.

Generally, a conventional light-emitting diode is manufactured by forming a laminated structure comprising an n-type semiconductor material layer, a light-emitting layer and a p-type semiconductor material layer on a substrate. When the conventional light-emitting diode uses different materials and structures, a wave length of the light emitted from the conventional light-emitting diode is also changed. For example, blue and green light-emitting diodes usually use sapphire as a substrate and GaInN epitaxial structure as a laminated structure. Since the sapphire is used as the substrate, an anode and a cathode of the conventional light-emitting diode are formed on the same surface of the substrate. Thus, the electrodes of the conventional light-emitting diode occupy a large area of the conventional light-emitting diode chip. That may result in an uneven distribution of electric current in the conventional light-emitting diode. Additionally, the brightness of the conventional light-emitting diode may decrease due to the light absorption of the electrodes.

### SUMMARY OF THE INVENTION

The primary objective of the present invention is to provide a light-emitting diode that can improve the diffusion current in the light-emitting diode.

The other objective of the present invention is to provide a high brightness light-emitting diode.

The present invention also provides a package structure having the LED and the method of manufacturing the LED.

A light-emitting diode in accordance with the present invention comprises a substrate, an n-type semiconductor, a luminous layer, a p-type semiconductor material layer, an anode and a cathode. The n-type semiconductor material layer is formed on the substrate and has a side surface, a center section and an edge around the center portion. The luminous layer is formed on the n-type semiconductor material layer. The p-type semiconductor material layer is formed on the luminous layer. The anode is formed on the p-type semiconductor material layer. The cathode is formed on the edge of and touches the n-type semiconductor material layer.

Preferably, a protective layer is formed on the p-type semiconductor material layer, wherein the anode penetrates the protective layer and contacts with the p-type semiconductor material layer.

Preferably, a transparent electrode layer is formed between the p-type semiconductor material layer and the anode and covering the p-type semiconductor material layer, wherein the protective layer covers the transparent electrode layer.

Preferably, the transparent electrode layer has a height of one quarter of the wave length of the light emitted from the LED, and the transparent electrode layer is made of a metallic oxide selected from the group consisting of ITO, RuO₂, NiO₂, ZnO and a combination thereof.

Preferably, the cathode is made of a non-light-absorption reflective metal or metallic oxide, and the cathode is made of a material selected from the group consisting of the Cr, Al, Ag, Au, Ti, ITO, ZnO, RuO₂ and a combination thereof.

Preferably, the cathode is formed on an edge of the n-type semiconductor material layer. The edge of the n-type semiconductor material layer on which the cathode is formed is thinner than the center section of the n-type semiconductor material layer to increase the thickness of the cathode. Alternatively, the cathode is formed on the substrate in contact with a side surface of the n-type semiconductor material layer. The height of the anode or cathode is larger than 2 µm.

The substrate is made of a material selected from the group consisted of Si, sapphire, SiC, ZnO, GaN.

According to another aspect of the present invention, a package structure of an LED is provided. The LED comprises a substrate, an n-type semiconductor material layer formed on a top surface of the substrate, a luminous layer formed on the n-type semiconductor material layer, a p-type semiconductor material layer being formed on the luminous layer, an anode formed on the p-type semiconductor material layer and a cathode formed along an edge of and electrically contacting with the n-type semiconductor material layer. The package of the LED further comprises a lead being formed on the anode and a conductive material formed on a bottom surface of the substrate and being in contact with the n-type semiconductor material layer and the cathode. The lead and the conductive material are respectively connected electrically to a lead frame used for being connected to an outer circuit.

According to a further aspect of the present invention, a manufacturing method for an LED is provided. The method comprises steps of providing a substrate, forming sequentially an n-type semiconductor material layer, a light-emitting layer and a p-type semiconductor material layer on a top surface of the substrate to form a laminated structure, etching, wherein an edge of the laminated structure is etched and removed till an edge of the n-type semiconductor material layer is exposed, forming a protective layer to cover the laminated structure and make the edge of the n-type semiconductor material layer exposed, forming a circular cathode on an edge of the n-type semiconductor material layer and forming an anode which penetrates the protective layer on the p-type semiconductor material layer.

In accordance with the present invention, since the cathode is formed along the edge of the n-type semiconductor material layer, electrical current can be distributed more evenly on a surface of the light-emitting diode. Additionally, due to the fact that the cathode is made of reflective material without light absorption, so the light emitted from the light-emitting diode can be less absorbed by the cathode. The cathode and the anode are formed thicker so that it can increase electrical current and improve the evenness of the current distribution of the LED.

Other objectives, advantages and novel features of the invention will become more apparent from the following detailed description when taken in conjunction with the accompanying drawings.

### BRIEF DESCRIPTION OF THE DRAWINGS

Fig. 1 is a cross sectional side view of a first embodiment of a light-emitting diode in accordance with the present invention;
Fig. 2 is a cross sectional side view of a second embodiment of the light-emitting diode in accordance with the present invention;
Fig. 3 is a cross sectional side view of a third embodiment of the light-emitting diode in accordance with the present invention;
Figs. 4A to 4E are cross sectional side views of steps of an embodiment of a manufacturing method of the light-emitting diode in accordance with the present invention;
Fig. 5 is a cross sectional side view of a first embodiment of a package structure of the light-emitting diode in accordance with the present invention;

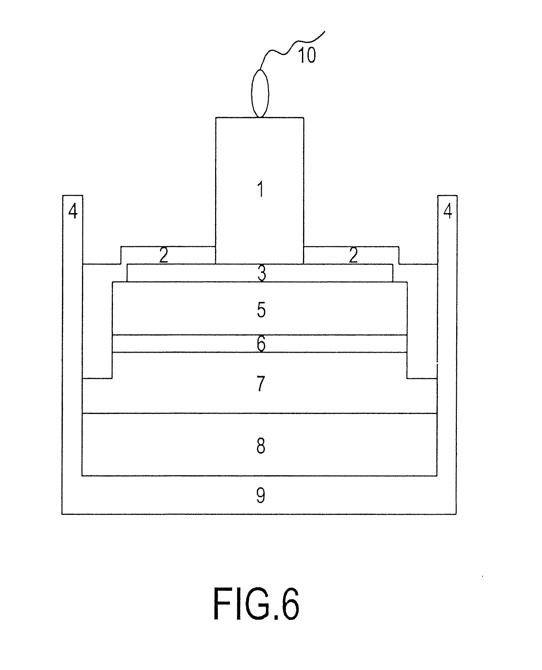

Fig. 6 is a cross sectional side view of a second embodiment of the package structure of the light-emitting diode in accordance with the present invention;

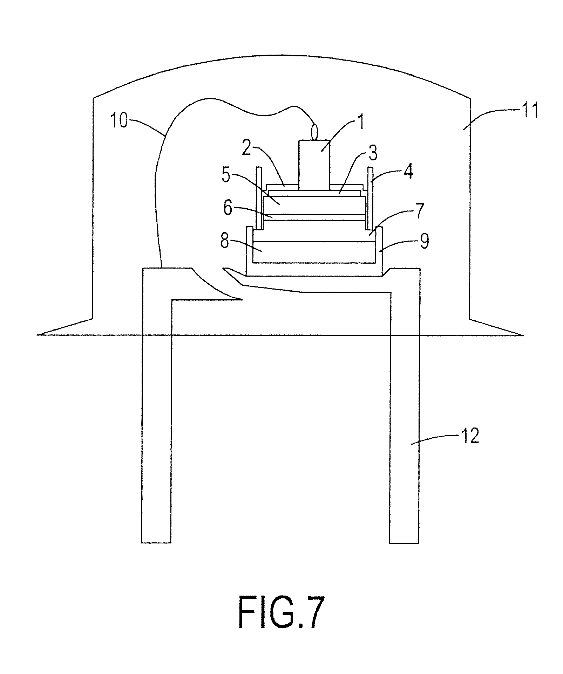

Fig. 7 is a side view in partial section of a third embodiment of the package structure of the light-emitting diode in accordance with the present invention; and
Fig. 8 is a top view of the first embodiment of the light-emitting diode in accordance with the present invention.

### DETAILED DESCRIPTION OF THE INVENTION

It can be further explained with the help of the appending drawings and implementing illustration.

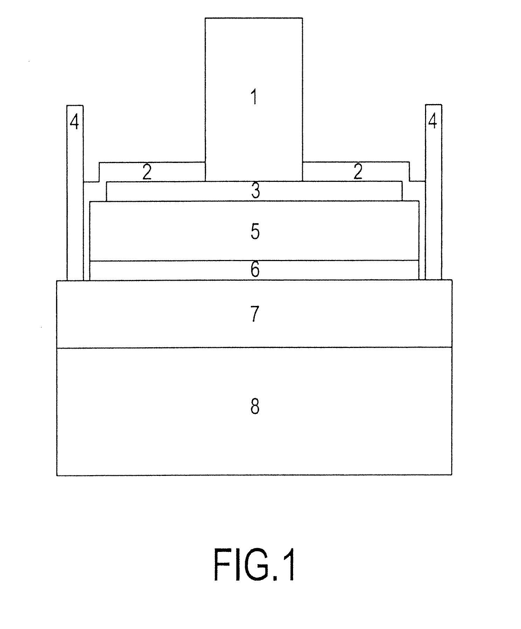

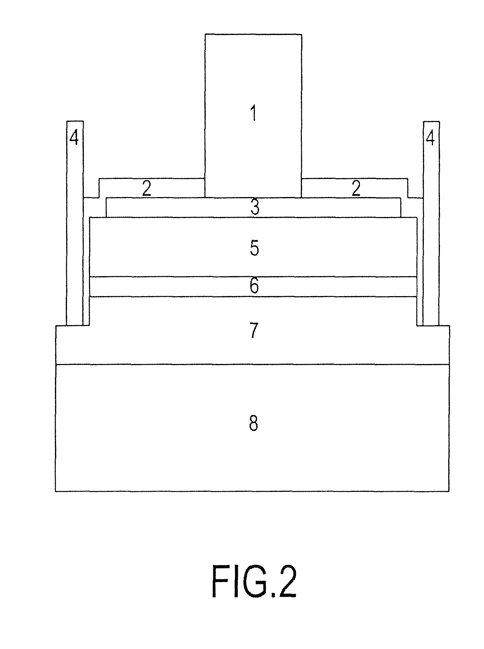

With reference to Figs. 1 and 2, a light-emitting diode in accordance with the present invention comprises a substrate 8, an n-type semiconductor material layer 7 formed on the substrate 8, a luminous layer 6 formed on the n-type semiconductor material layer 7 and a p-type semiconductor material layer 5 formed on the luminous layer 6. The n-type semiconductor material layer 7, the luminous layer 6 and the p-type semiconductor material layer 5 can be made of a semiconductor material like as gallium nitride. The LED may further comprise a transparent electrode layer 3 formed on and covering the p-type semiconductor material layer 5 and may be made of a metallic oxide selected from the group consisting of ITO, RuO₂, NiO₂, ZnO and a combination thereof. The transparent electrode layer 3 may have a height of one quarter of the wave length of the light emitted from the light-emitting diode. The anode 1 is formed on a top at a center of the transparent electrode layer 3 and may be columnar. Notably, the transparent electrode layer 3 can improve an evenness of the current distribution of the light-emitting diode but is not necessary. The anode 1 may be formed on the p-type semiconductor material layer 5 directly.

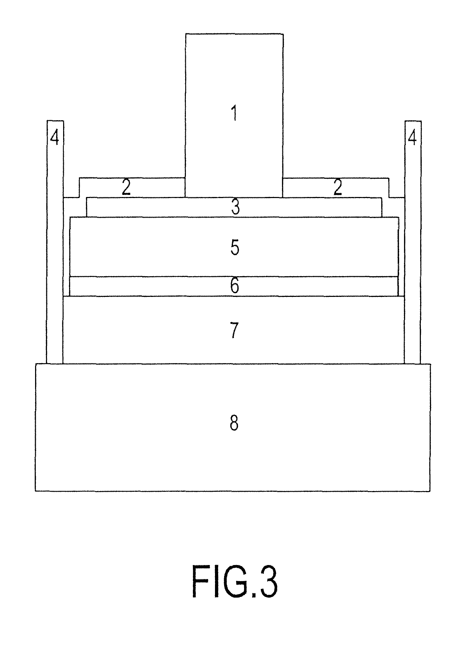

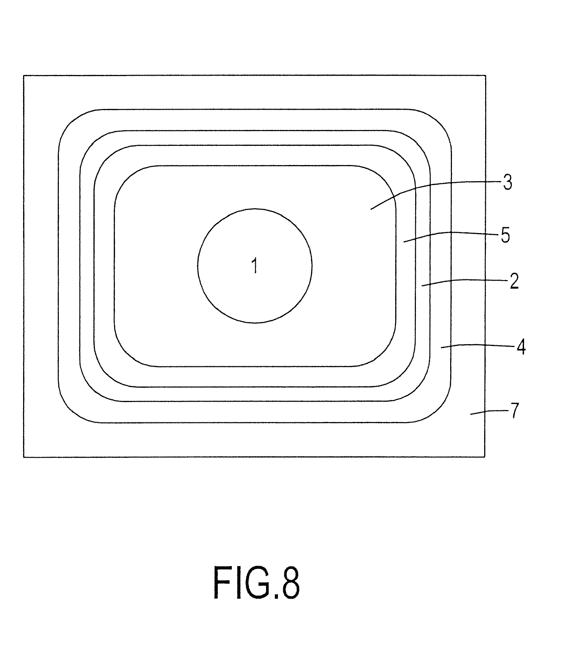

The cathode 4 is formed along the edge of the n-type semiconductor material layer 7 and is in contact with the n-type semiconductor material layer 7 as shown in Fig. 1. With further reference to Fig. 8, the cross section of the cathode 4 may be annular, such as a circular, oblong or polygonal loop-shaped composed of straight and curve lines and may have an identical shape from top to bottom. The edge of the n-type semiconductor material layer 7 is thinner than the center section of the n-type semiconductor material layer 7A so as to form a shape of a step on the edge. The cathode 4 may also be formed on the step of the n-type semiconductor material layer 7A as shown in Fig. 2 so as to increase the height of the cathode 4. The cathode 4 may also be formed on the substrate 8 in contact with the side surface of the n-type semiconductor material layer 7 as shown in Fig. 3. The cathode 4 may be made of a non-light-absorption reflective metal or metallic oxide selected from the group consisting of the Cr, Al, Ag, Au, Ti, ITO, ZnO, RuO₂ and a combination thereof so as to reduce the light absorption of the cathode 4. The cathode 4 may have a height higher than 2 µm. An ohmic contact layer may be formed between the cathode 4 and the n-type semiconductor layer 7.

The protective layer 2 is formed on the top of the transparent electrode layer 3 and separates the cathode 4 from the transparent electrode layer 3 so as to prevent the cathode 4 from being in contact with the transparent electrode layer 3. The protective layer 2 may be made of an insulator such as SiO₂, Si₃N₄, SiNO, TiO₂, SOG or the like.

Since the cathode 4 is annular, electrical current can be distributed more evenly on a surface of the light-emitting diode. Additionally, the cathode 4 is formed on the step of the n-type semiconductor material layer 7, so the cathode 4 can be formed higher in order to increase electrical current and improve the evenness of the current distribution of the light-emitting diode. Furthermore, because the cathode 4 is made of non-light-absorption reflective material, the light emitted from the light-emitting diode does not be absorbed by the cathode 4 and the brightness of the light-emitting diode is enhanced.

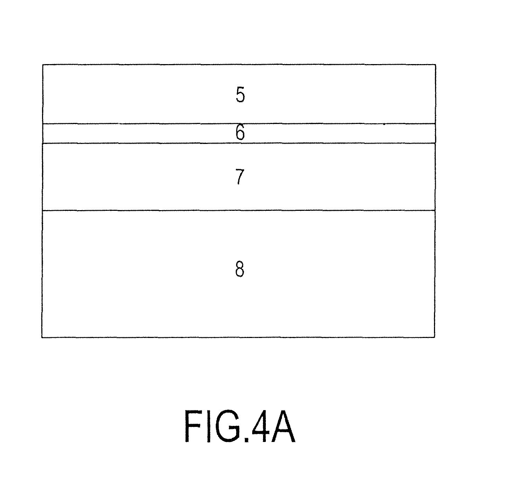

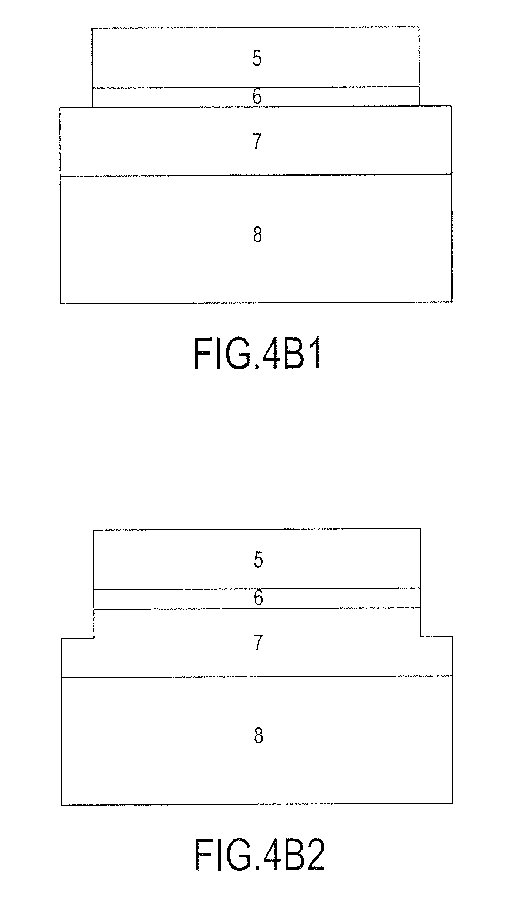

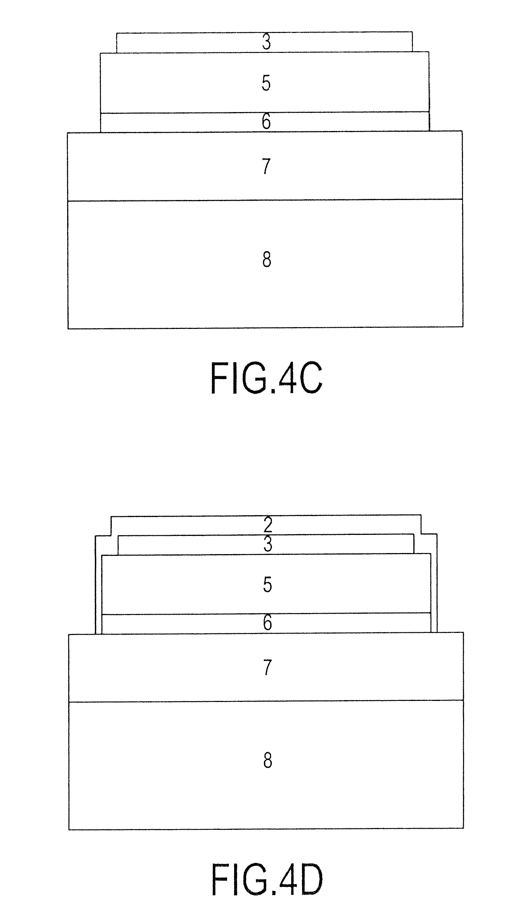

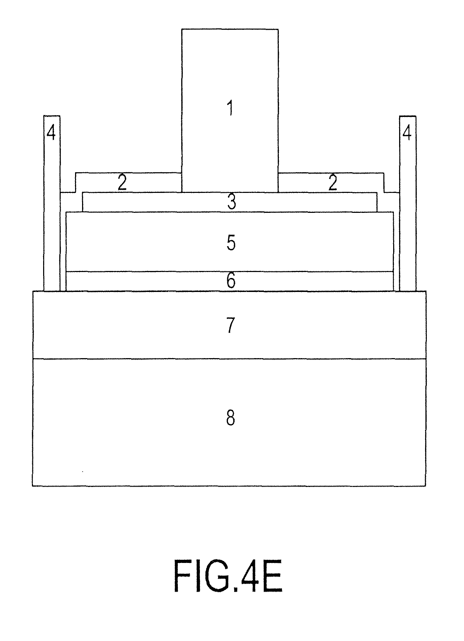

With reference to Figs. 4A to 4E, a manufacturing method for the light-emitting diode may comprise steps of providing a substrate 8. The substrate 8 may be Si, sapphire, SiC, ZnO, GaN or the like and may have a height from 5 µm to 100 µm. Then, a laminated structure is formed on the substrate 8 and comprises sequentially an n-type semiconductor material layer 7, a light-emitting layer 6 and a p-type semiconductor material layer 5 as shown in Fig. 4A. The laminated structure may be made of semiconductor materials like gallium nitride and may be formed by using an epitaxial process. An edge of the laminated structure is etched and removed till an edge of the n-type semiconductor material layer 7 is exposed as shown in Fig. 4B1. The edge of the n-type semiconductor material layer 7 can be further etched to make the edge of the n-type semiconductor material layer 7 be thinner than the center section of the n-type semiconductor material layer 7 so as to form a step on the edge as shown in Fig. 4B2. A transparent electrode layer 3 is formed on the p-type semiconductor material layer 5 by masking and coating as shown in Fig. 4C. A protective layer 2 is formed to cover the transparent electrode layer 3 and the laminated structure but the edge of the n-type semiconductor material layer 7 is still exposed as shown in Fig. 4D. A cathode 4 is formed along the edge of the n-type semiconductor material layer 7 and an anode 1 extends through the protective layer 2 and is formed on the top at a center section of the transparent electrode layer 3 as shown in Fig. 4E. The cathode 4 and the anode 1 may be formed by coating process sequentially or simultaneously and may have a height higher than 2 µm. Additionally, the transparent electrode layer 3 can be omitted.

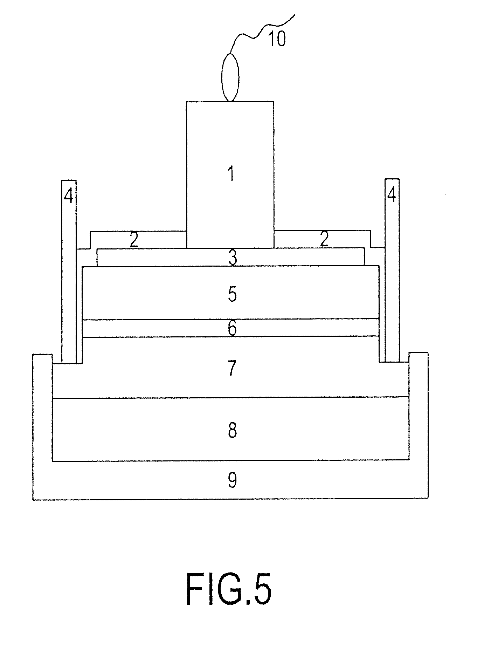

The substrate 8 of the above light-emitting diode is cut to decrease the height of the substrate 8. Then a conductive material 9 such as plating metal or conductive adhesive is formed on the bottom surface of the substrate 8 and is in contact with the n-type semiconductor material layer 7. A lead 10 is connected to the anode 1 to form a package structure as shown in Fig. 4. Preferably, the conductive material 9 such as the plating metal or conductive adhesive 9 is formed integrally with the cathode 4 as a single part so as to simplify manufacturing processes. Then, the lead 10 and the conductive material 9 such as the plating metal or conductive adhesive are respectively connected electrically to a lead frame 12 to form a package structure and the package structure is disposed in a cover 11 filled with epoxy resin as shown in Fig. 5.

Since the cathode 4 is formed along the edge of the n-type semiconductor material layer 7, electrical current can be distributed more evenly on a surface of the light-emitting diode. Additionally, due to the fact that the cathode 4 is made of reflective material without light absorption, so the light emitted from the light-emitting diode can be less absorbed by the cathode 4. The cathode 4 and the anode 1 is formed thicker so that it can increase electrical current and improve the evenness of the current distribution of the LED. The light-emitting efficiency of the LED is 50 % higher than that of the conventional LED.

The present invention can be utilized in a high brightness LED.

## Claims

1. An LED comprising:
a substrate;
an n-type semiconductor material layer formed on a top surface of the substrate;
a luminous layer formed on the n-type semiconductor material layer;
a p-type semiconductor material layer being formed on the luminous layer;
an anode formed on the p-type semiconductor material layer; and
a cathode formed along an edge of and electrically contacting with the n-type semiconductor material layer.

2. The LED as claimed in claim 1 further comprising a protective layer formed on the p-type semiconductor material layer, wherein the anode penetrates the protective layer and contacts with the p-type semiconductor material layer.

3. The LED as claimed in claim 1 further comprising a transparent electrode layer formed between the p-type semiconductor material layer and the anode and covering the p-type semiconductor material layer, wherein the protective layer covers the transparent electrode layer.

4. The LED as claimed in claim 3, wherein the transparent electrode layer has a height of one quarter of the wave length of the light emitted from the LED.

5. The LED as claimed in claim 3 or 4, wherein the transparent electrode layer is made of a metallic oxide selected from the group consisting of ITQ, RuO₂, NiO₂, ZnO and a combination thereof.

6. The LED as claimed in claim 1, wherein the cathode is a circular, oblong or polygonal or loop-shaped composed of straight and curve lines.

7. The LED as claimed in claim 1, wherein the cathode is made of a non-light-absorption reflective metal or metallic oxide.

8. The LED as claimed in claim 1, 2, 3, 4, 6 or 7, wherein the cathode is made of a material selected from the group consisting of the Cr, Al, Ag, Au, Ti, ITO, ZnO, RuO₂ and a combination thereof.

9. The LED as claimed in claim 1, the cathode is formed on an edge of the n-type semiconductor material layer.

10. The LED as claimed in claim 9, wherein the edge of the n-type semiconductor material layer on which the cathode is formed is thinner than the center section of the n-type semiconductor material layer.

11. The LED as claimed in claim 1, wherein the cathode is formed on the substrate in contact with a side surface of the n-type semiconductor material layer.

12. The LED as claimed in claim 1, 2, 3. 9, 10 or 11, wherein the height of the anode or cathode is larger than 2 µm.

13. The LED as claimed in claim 1, 2, 3, 9, 10 or 11 further has ohmic contact layers formed between the cathode and the n-type semiconductor material layer and between the anode and the p-ype semiconductor material layer.

14. The LED as claimed in claim 1, wherein the substrate is made of a material selected from the group consisted of Si, sapphire, SiC, ZnO, GaN.

15. The LED as claimed in claim 1, wherein the LED is a high brightness LED.

16. A package structure of an LED comprising:
an LED comprising:
a substrate;
an n-type semiconductor material layer formed on a top surface of the substrate;
a luminous layer formed on the n-type semiconductor material layer;
a p-type semiconductor material layer being formed on the luminous layer;
an anode formed on the p-type semiconductor material layer; and
a cathode formed along an edge of and electrically contacting with the n-ype semiconductor material layer;
a lead being formed on the anode; and
a conductive material formed on a bottom surface of the substrate and being in contact with the n-type semiconductor material layer and the cathode, wherein
the lead and the conductive material are respectively connected electrically to a lead frame used for being connected to an outer circuit.

17. The package structure of an LED as claimed in claim 16 further comprising a protective layer formed on the p-type semiconductor material layer, wherein the anode penetrates the protective layer and contacts with the p-type semiconductor material layer.

18. The package structure of an LED as claimed in claim 16 further comprising a transparent electrode layer formed between the p-type semiconductor material layer and the anode and covering the p-type semiconductor material layer, wherein the protective layer covers the transparent electrode layer.

19. The package structure of an LED as claimed in claim 16, wherein the transparent electrode layer has a height of one quarter of the wave length of the light emitted from the LED.

20. The package structure of an LED as claimed in claim 18 or 19, wherein the transparent electrode layer is made of a metallic oxide selected from the group consisting of ITO, RuO₂, NiO₂, ZnO and a combination thereof.

21. The package structure of an LED as claimed in claim 16, wherein the cathode is a circular, oblong or polygonal or loop-shaped composed of straight and curve lines.

22. The package structure of an LED as claimed in claim 16, wherein the cathode is made of a non-light-absorption reflective metal or metallic oxide.

23. The package structure of an LED as claimed in claim 16, 17, 18, 21 or 22, wherein the cathode is made of a material selected from the group consisting of the Cr, Al, Ag, Au, Ti, ITO, ZnO, RuO₂ and a combination thereof.

24. The package structure of an LED as claimed in claim 16, the cathode is formed on an edge of the n-type semiconductor material layer.

25. The package structure of an LED as claimed in claim 24, wherein the edge of the n-type semiconductor material layer on which the cathode is formed is thinner than the center section of the n-type semiconductor material layer.

26. The package structure of an LED as claimed in claim 16. wherein the cathode is formed on the substrate in contact with a side surface of the n-type semiconductor material layer.

27. The package structure of an LED as claimed in claim 26, wherein the conductive material and the cathode are formed as a single part.

28. The package structure of an LED as claimed in claim 16, 17, 18, 24, 25 or 26, wherein the height of the anode or cathode is larger than 2 µm.

29. The package structure of an LED as claimed in claim 16, 17, 18, 24, 25 or 26 further has ohmic contact layers formed between the cathode and the n-type semiconductor material layer and between the anode and the p-type semiconductor material layer.

30. The package structure of an LED as claimed in claim 16, wherein the substrate is made of a material selected from the group consisted of Si, sapphire, SiC, ZnO, GaN.

31. The package structure of an LED as claimed in claim 16, wherein the LED is a high brightness LED.

32. A manufacturing method for an LED comprising steps of providing a substrate;
forming sequentially an n-type semiconductor material layer, a light-emitting layer and a p-type semiconductor material layer n a top surface of the substrate to form a laminated structure;
etching, wherein an edge of the laminated structure is etched and removed till an edge of the n-type semiconductor material layer is exposed;
forming a cathode on an edge of the n-type semiconductor material layer; and
forming an anode on the p-type semiconductor material layer.

33. The manufacturing method for an LED as claimed in claim 32 further comprises a step of forming a protective layer to cover the laminated structure and make the edge of the n-type semiconductor material layer exposed.

34. The manufacturing method for an LED as claimed in claim 32 further comprising a step of forming a transparent electrode layer between the p-type semiconductor material layer and the cathode and covering the p-type semiconductor material layer.

35. The manufacturing method for an LED as claimed in claim 32, wherein the edge of the n-type semiconductor material layer is thinner than the center section of the n-type semiconductor material layer.
